# EUROPEAN PATENT APPLICATION

(11) **EP 4 679 502 A1**
(43) Date of publication of application: **14.01.2026**
(21) Application number: 23926452.6
(22) Date of filing: 11.12.2023
(51) Int. Cl.: H01L 23/36, H01L 23/473

(54) **COOLER**

(30) Priority: 09.03.2023 JP 2023036513
(71) Applicant: Nikkeikin Almo Company, Ltd., Tokyo 105-8681 (JP)
(72) Inventor: SEKI, Kazuhito, Shizuoka-shi, Shizuoka 421-3297 (JP)
(74) Representative: TBK
(86) International application number: PCT/JP2023/044162
(87) International publication number: WO 2024/185248

(57) **Abstract**

To provide a cooling device for a cooling device configured to have an enhanced cooling performance at each cooling site to cope with a temperature difference in a heating element, and to utilize coolant effectively.

The cooling device 1 comprises: an upper plate 10 serving as a heat receiving surface; a lower plate 20 being in parallel and opposed to the upper plate; and a single or plurality of flow path(s) 2 formed by joining the upper plate 10 and the lower plate 20. A single or plurality projection(s) 5 projecting to the upper plate 10 or the lower plate 20 is/are formed in an intermediate section of any of the flow paths 2, and the projection 5 has a height that does not reach the upper plate or the lower plate opposed thereto.

## Description

### Technical Field

The present invention relates to a cooling device for removing the heat from e.g., a vehicular battery of an electric vehicle and a hybrid vehicle, a power device such as an inverter, and a semiconductor element.

### Background Art

In general, in vehicles such as electric vehicles and hybrid vehicles, a battery is employed as a power source of a motor for propelling the vehicle.

In order to launch and accelerate the vehicle by operating the motor and to control the vehicle when decelerating the vehicle abruptly by applying a brake, a battery having a large capacity is employed in the vehicle.

Therefore, in order to prevent a reduction in performance of the battery due to a temperature rise, it is necessary to compulsory cool the battery using a cooling device.

In the prior art, there is known a cooling device having a structure in which a flow path of a cooling liquid is formed in a cooling plate (cooling device) disposed on a bottom of the battery, so that the cooling device is cooled by a vaporization heat of the cooling liquid and that the battery is cooled by transferring the heat of the battery to the cooled cooling device (for example, see Japanese Patent Laid-Open No. 2010-50000).

According to one embodiment of the cooling device described in Japanese Patent Laid-Open No. 2010-50000, radiating fins are fixed to aluminum flat pipes arranged parallel to each other to serve as the plow paths of the looing liquid.

According to the teachings of Japanese Patent Laid-Open No. 2010-50000, the battery in which a plurality of battery cells are connected to one another may be cooled by supplying the cooling liquid to the cooling device attached to the bottom of the battery in which a plurality of the battery cells are connected to one another.

### Summary of Invention

### Technical Problem to be Solved by the Invention

However, a thermal boundary layer derived from a temperature difference interposes between the battery cells, and a temperature difference exists between a heat source and a site away from a center of the heat source. Therefore, a surface temperature of the cooing device may be varied (a temperature deviation) and the cooling performance of the cooling device may not be exerted sufficiently at each cooling site.

Likewise, in a case of cooling a heating element other than the battery e.g., a power device such as an inverter and a semiconductor element, a surface temperature of the cooing device may be varied and the cooling performance of the cooling device may not be exerted sufficiently at each cooling site.

The present invention has been conceived noting the foregoing technical problems, and it is therefore an object of the present invention to provide a cooling device configured to have an enhanced cooling performance at each cooling site to cope with a temperature difference in a heating element, and to utilize coolant effectively.

### Means for Solving the Problem

In order to achieve the above-explained objectives, according to the present invention, there is provided a cooling device comprising: an upper plate serving as a heat receiving surface; a lower plate being in parallel and opposed to the upper plate; and a single or plurality of flow path(s) formed by joining the upper plate and the lower plate. In order to achieve the above-explained objective, a single or plurality of projection(s) projecting to the upper plate or the lower plate is/are formed in an intermediate section of any of the flow paths, and the projection has a height that does not reach the upper plate or the lower plate opposed thereto. In addition, it is preferable to open the flow path wider toward the upper plate.

According to the above-explained configuration, the flow paths are formed by joining the lower plate and the upper plate, and heights of the flow paths are reduced. Therefore, cross-sectional areas of the flow paths are reduced so that a flow velocity is increased to enhance the cooling performance. Moreover, since the projections are formed in the intermediate section of any of the flow paths and each of the projections have a height at which the projections do not reach the upper plate or the lower plate, a cross-sectional area of the flow path may be reduced locally. Therefore, a flow velocity of coolant may be increased, and the coolant flowing near the bottom of the flow path may be guided toward the surface close to the heat source. In addition, since the flow path is opened wider toward the upper plate, a contact area between the coolant and the upper plate may be widened thereby enhancing the cooling performance.

According to the present invention, it is preferable to shape an upper surface of the projection into a flat surface being in parallel to the upper plate or the lower plate opposed thereto.

By this configuration, the coolant flowing between the projection and the upper plate or the lower plate may be streamed to increase a flow velocity.

In a case that the single flow path is employed, a linear flow path may serve as the flow path of the present invention. However, it is preferable to form the flow path into a meandering path in which linear sections extend parallel to one another, and the linear sections are joined together in an inlet side and in an outlet side.

In addition, it is preferable to form the projections in the flow path extending in a site away from the heat source being in contact with the upper plate.

By this configuration, the coolant flowing through the site away from the heat source without being involved in the heat exchange may be reduced.

In addition, according to the present invention, the lower plate may comprise a plurality of ridges formed in parallel to form the flow path, and it is preferable to join the ridges to the upper plate.

By this configuration, a plurality of the linear flow paths may be formed in parallel to one another by joining the upper plate to the lower plate.

In addition, it is preferable to form the projections integrally with any one of the upper plate and the lower plate.

By this configuration, the projections for increasing the flow velocity of the coolant may be formed easily.

### Advantageous Effects of Invention

Since the present invention is structured as explained above, the following advantages may be achieved.
(1) According to claims 1, 2, 3, and 4 of the present invention, a cross-sectional area of the flow path may be reduced by reducing a height of the flow path so that a flow velocity is increased to enhance the cooling performance, and that the coolant flowing near the bottom of the flow path may be guided toward the surface close to the heat source. Therefore, the heat exchanging performance at each cooling site may be improved to cope with a temperature difference in the heat source, and the coolant may be utilized effectively.
(2) According to claim 5 of the present invention, the coolant flowing through the site away from the heat source without being involved in the heat exchange may be reduced. Therefore, in addition to the advantage (1), the coolant may be utilized more effectively.
(3) According to claim 6 of the present invention, a plurality of the flow paths may be formed in parallel to one another by joining the upper plate and the lower plate. Therefore, in addition to the advantages (1) and (2), the cooling device may be manufactured easily.
(4) According to claim 7 of the present invention, the projections for increasing the flow velocity of the coolant may be formed easily. Therefore, in addition to the advantages (1) to (3), the number of parts may be reduced and the colling device may be manufactured easily.

### Brief Description of Drawings

[Fig. 1] (a) is a schematic plan view showing a cooling device according to the first example of the present invention, and (b) is a partially omitted enlarged side view.
[Fig. 2] is a cross-sectional view showing a main part of the cooling device according to the present invention.
[Fig. 3] is an enlarged cross-sectional view along the I-I line drawn in Fig. 2.
[Fig. 4] is a cross-sectional perspective view showing the main part of the cooling device according to the present invention.
[Fig. 5] is a schematic plan view showing a flow of the coolant in an example in which the projections are formed in the linear flow path.
[Fig. 6] is a schematic plan view showing a cooling device according to the second example of the present invention.
[Fig. 7] is a schematic plan view showing a flow of the coolant in an example in which the projections are formed in the flow path according to the second example.

### Description of Embodiment(s)

Hereinafter, examples of the cooling device according to the present invention will be described in detail with reference to the accompanying drawings. In the following description, examples of the cooling device for removing the heat emitted from a vehicular battery will be explained.

### <First Example>

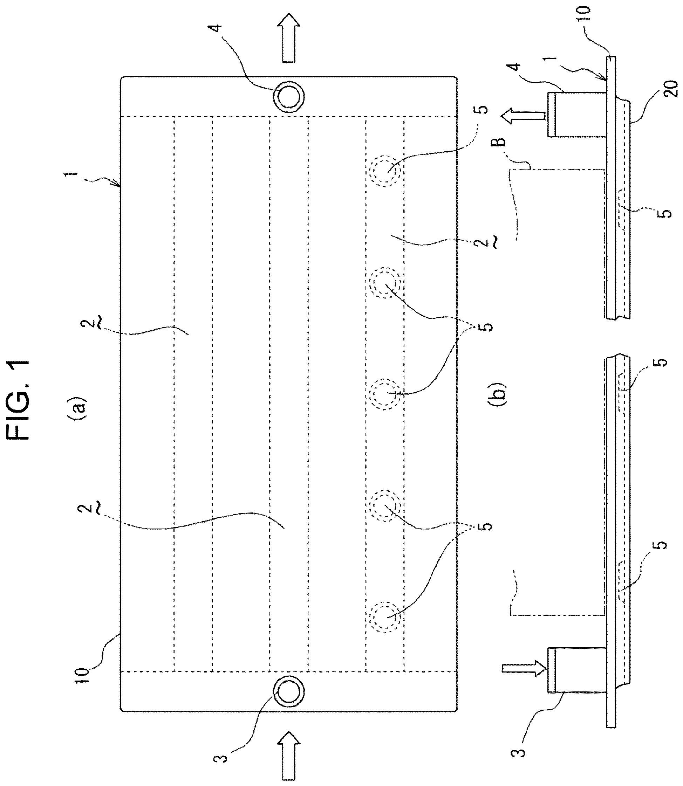

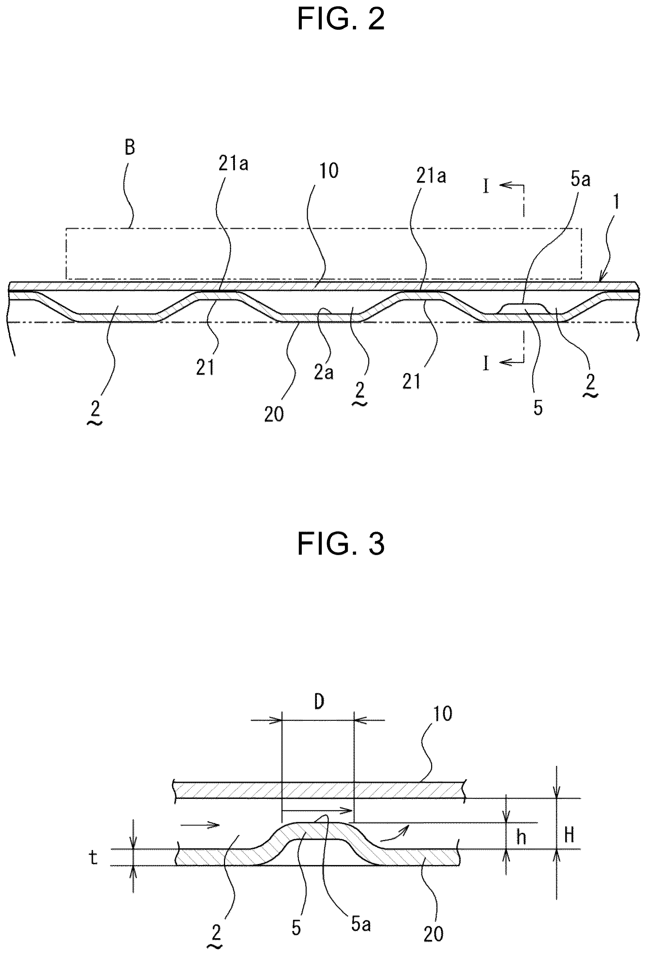

As illustrated in FIGs. 1 and 2, the cooling device 1 according to the first example of the present invention comprises: an upper plate 10 having a heat receiving surface attached to a bottom of a battery B in which a plurality of battery cells (not shown) are joined to one another and which is adopted as e.g., a power source of a motor for propelling a vehicle; and a lower plate 20 disposed in parallel with the upper plate 10; and a plurality of linear flow paths 2 formed by combining the upper plate 10 with the lower plate 20. In addition, in order to increase a flow velocity of the coolant, projections 5 are formed in an intermediate section of any of the linear flow paths 2. Further, a coolant inlet pipe 3 and a coolant outlet pipe 4 are joined to each end of the cooling device 1.

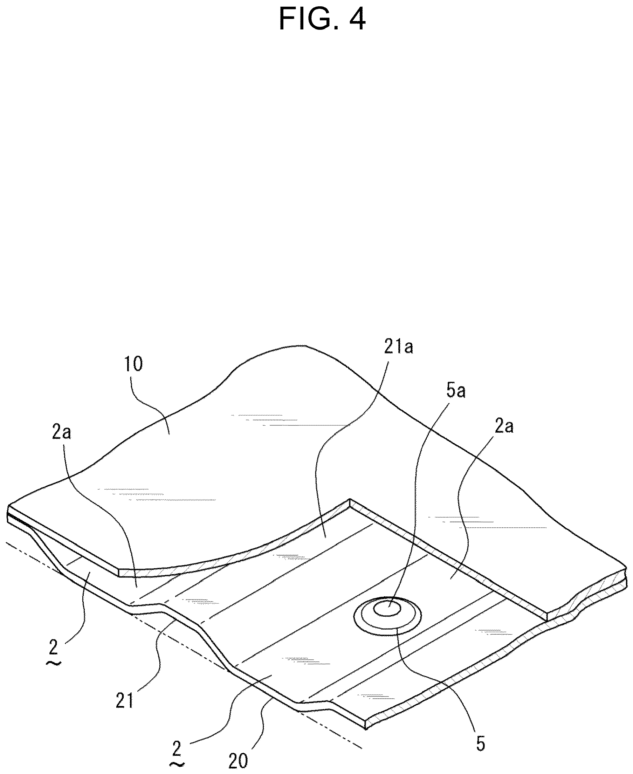

The lower plate 20 is formed of aluminum material. As illustrated in FIGs. 2 and 4, in the lower plate 20, a plurality of ridges 21 are formed in parallel by pressing the lower plate 20 thereby forming the linear flow paths 2, and the projections 5 are arranged at certain intervals in the linear flow path 2 while being isolated away from the battery B as a heating element being in contact with the upper plate 10. Bottom surfaces 2a of the linear flow paths 2 and upper surfaces 21a of the ridges 21 are individually shaped into a flat surface. A side edge of the linear flow path 2 and a side edge of the ridge 21 are joined together through a slant bridge so that the linear flow path 2 opens wider toward the upper plate 10. Since the linear flow path 2 opens wider toward the upper plate 10, a contact area between the coolant and the upper plate 10 may be widened thereby enhancing the cooling performance.

The projection 5 is formed by pressing the lower plate 20 into a truncated conical shape raising from the bottom surface of the lower plate 20 and having a flat upper surface 5a, and the projection 5 has a height at which the upper surface 5a does not reach the upper plate 10. Specifically, in this example, a thickness t of the lower plate 20 is set within a range from 1.0 mm to 3.0 mm, a diameter D of the projection 5 is set to 6 mm, and a height h of the projection 5 is set to 1 mm. In order to prevent a clog by a foreign mater, a height H of the linear flow path 2 is set to 2.5 mm. Nonetheless, dimensions of the lower plate 20 should not be limited to the foregoing dimensions.

As explained above, the lower plate 20 is formed integrally with the ridges 21 and the projections 5, and joined to the upper plate 10 formed of aluminum by brazing the ridges 21 to the upper plate 10.

To this end, for example, the upper plate 10 or the lower plate 20 may be formed of a brazing sheet to which brazing material is applied to a surface thereof. Instead, the upper plate 10 and the lower plate 20 may also be brazed together by applying brazing material to one of those plates.

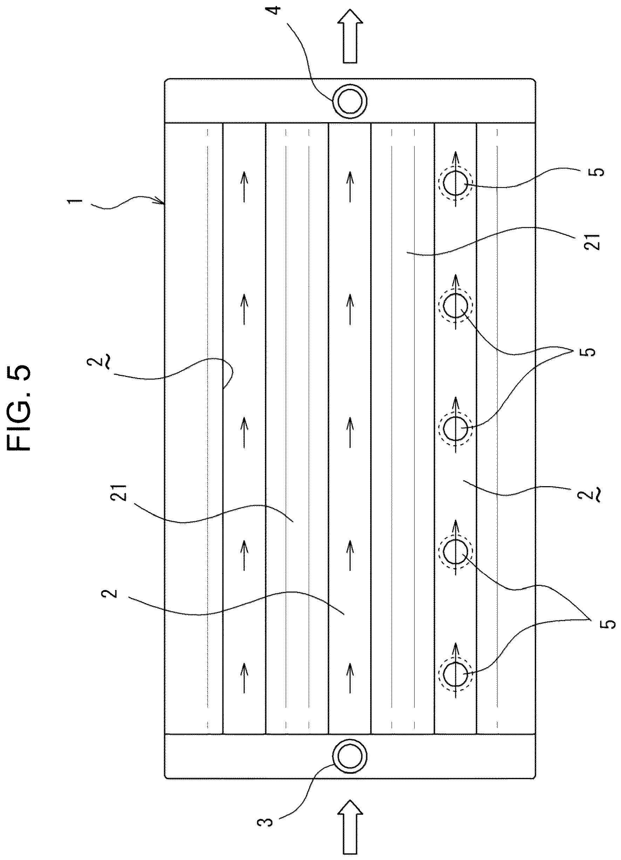

As illustrated in FIG. 5, in the cooling device 1 thus structured, the coolant supplied to the cooling device 1 through the coolant inlet pipe 3 flows through each of the linear flow paths 2. In this situation, in the flow path 2 in which the projections 5 are formed, a flowing area between the upper plate 10 and the flat upper surfaces 5a of the projections 5 situated lower than the upper plate 10 may be reduced locally. That is, a cross-sectional area of the flow path 2 between the upper surface 5a of the projection 5 and the upper plate 10 is reduced by the projection 5 so that a flow velocity of the coolant is increased and that the coolant flowing near the bottom of the flow path is guided toward the surface close to the battery B as a heat source. Therefore, a heat exchanging performance may be improved.

Here, in the foregoing example, three rows of the linear flow paths 2 are formed. Nonetheless, the number of the linear flow paths 2 should not be limited to the foregoing example, and may be altered arbitrarily other than one row or three rows. In addition, in the foregoing example, the projections 5 are formed in the linear flow path 2 extending along one side of the cooling device in the width direction. However, locations of the projections 5 should not be limited to the foregoing example, and may be formed in another one of linear flow paths 2 at certain intervals while being isolated away from the battery B. For example, in a case that the batteries B are arranged at certain intervals in the flowing direction of the coolant, the projections 5 may be formed in the linear flow path 2 where the battery B is not arranged.

Further, in the foregoing example, the projections 5 are formed on the lower plate 20. Instead, the projections 5 may also be formed on a lower surface of the upper plate 10 as long as the heat receiving surface of the upper plate 10 is flat enough.

### <Second Example>

According to the second example, a single flow path is formed in the cooling device. In the following descriptions of the second example, explanations for the elements in common with those of the first example will be omitted.

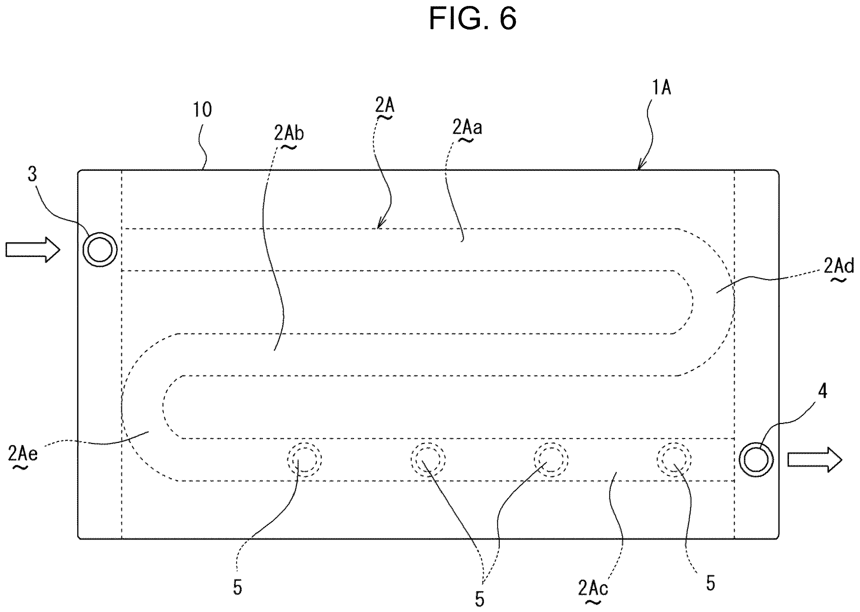

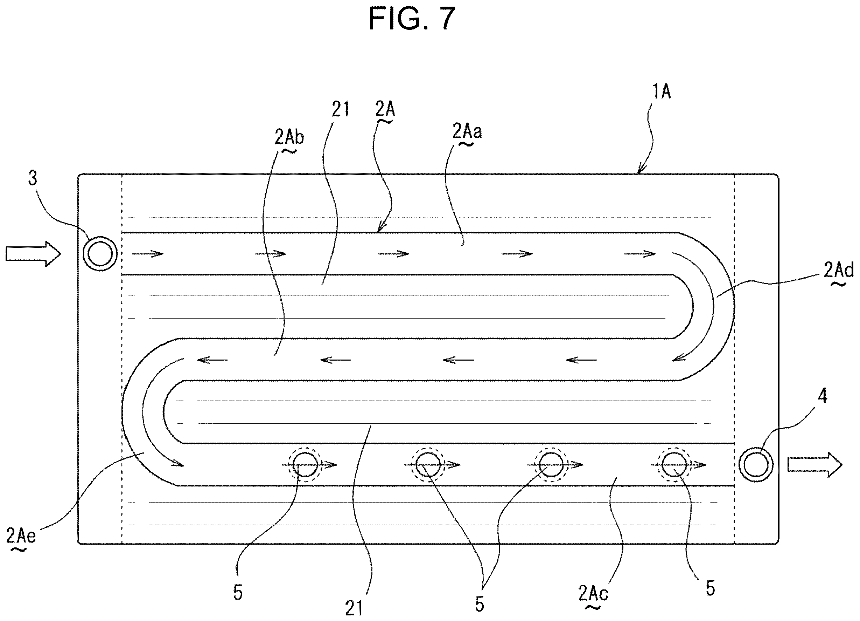

As illustrated in Figs. 6 and 7, in a cooling device 1A according to the second example, a flow path 2A is shaped into a meandering path comprising linear sections extending parallel to one another, a connecting section 2Ad in the outlet side, and a connecting section 2Ae in the inlet side. In other words, the flow path 2A comprises a first linear section 2Aa in which the coolant supplied from the coolant inlet pipe 3 flows toward the outlet side, a second linear section 2Ab in which the coolant flows toward the inlet side, and a third linear section 2Ac in which the coolant flows toward the outlet side. The linear sections adjoining to one another extend in parallel to one another, the first linear section 2Aa and the second linear section 2Ab are joined together through a first arcuate connecting section 2Ad, and the second linear section 2Ab and the third linear section 2Ac are joined together through a second arcuate connecting section 2Ae.

Likewise, in the cooling device 1A according to the second example, a plurality of the ridges 21 are also formed in the lower plate 20 to form the first to third linear sections 2Aa, 2Ab, and 2Ac.

In the above-explained flow path 2A, the third linear section 2Ac extends in a site away from the battery B, and the projections 5 are formed in the third linear section 2Ac at certain intervals.

In the above-explained cooling device 1A according to the second example, as illustrated in FIG. 7, the coolant supplied to the cooling device 1A from the coolant inlet pipe 3 flows through the first linear section 2Aa → the first connecting section 2Ad → the second linear section 2Ab → the second connecting section 2Ae → the third linear section 2Ac. In this situation, in the third linear section 2Ac in which the projections 5 are formed, a flowing area between the upper plate 10 and the flat upper surfaces 5a of the projections 5 situated lower than the upper plate 10 may be reduced locally. That is, a cross-sectional area of the flow path between the upper surface 5a of the projection 5 and the upper plate 10 is reduced by the projection 5 so that a flow velocity of the coolant is increased and that the coolant flowing near the bottom of the flow path is guided toward the surface close to the battery B as a heat source. Therefore, a heat exchanging performance may be improved.

Here, in the foregoing example, the flow path 2A includes three rows of the linear sections 2Aa, 2Ab, and 2Ac, and two arcuate connecting sections 2Ad and 2Ae. However, the numbers of the linear sections and the connecting sections should not be limited to the foregoing example, and the number of the linear sections may be altered to (n) rows (e.g., 4 or 5 rows) instead of 3 rows, and the number of the connecting section may be altered to (n-1).

Thus, according to the cooling devices 1 and 1A having the above-explained structures, the flow paths 2 and 2A are formed by joining the lower plate 20 to the upper plate 10, and heights of the flow paths 2 and 2A are reduced. Therefore, the cross-sectional areas of the flow paths are reduced so that the flow velocity of the coolant is increased to enhance the cooling performance. Moreover, since the flow paths 2 and 2A open wider toward the upper plate 10, the contact area between the coolant and the upper plate 10 may be widened thereby enhancing the cooling performance. Further, the projections 5 whose heights are lower than the upper plate 10 or the lower plate 20 opposed thereto are formed in the intermediate section of any of the plow paths 2 or 2A so that the cross-sectional area of the flow path may be reduced locally by the projections 5. Therefore, a flow velocity of the coolant may be increased between the upper surface 5a of the projection 5 and the upper plate 10, and the coolant flowing near the bottom of the flow path may be guided toward the surface close to the battery B as a heat source. For these reasons, the heat exchanging performance at each cooling site may be improved to cope with a temperature difference in the battery B, and the coolant may be utilized effectively.

In addition, the projections 5 are formed in the flow path 2 or 2A (the third linear section 2Ac) extending in a site away from the battery B as a heat source being in contact with the upper plate 10. Therefore, the coolant flowing through the site away from the battery B without being involved in the heat exchange may be reduced so that the coolant may be utilized efficiently.

As explained above, in the foregoing examples, the cooling devices 1 and 1A according to the present invention are adapted to remove the heat from the battery B employed as a power source for propelling the vehicle. However, the cooling devices 1 and 1Aaccording to the present invention should not be limited to the foregoing examples, and may be adapted to remove heat from e.g., a power device such as an inverter and a heating element such as a semiconductor element.

## Claims

1. A cooling device, comprising:
an upper plate serving as a heat receiving surface;
a lower plate being in parallel and opposed to the upper plate; and
a single or plurality of flow path(s) formed by joining the upper plate and the lower plate,
**characterized in that**:
a single or plurality of projection(s) projecting to the upper plate or the lower plate is/are formed in an intermediate section of any of the flow paths formed on the upper plate or the lower plate, and the projection has a height that does not reach the upper plate or the lower plate opposed thereto.

2. The cooling device as claimed in claim 1, wherein the flow path opens wider toward the upper plate.

3. The cooling device as claimed in claim 1, wherein the projection comprises a flat upper surface formed in parallel to the upper plate or the lower plate opposed thereto.

4. The cooling device as claimed in claim 1 or 2, wherein the single flow path is shaped into a meandering path in which linear sections extend parallel to one another, and the linear sections are joined together in an inlet side and in an outlet side.

5. The cooling device as claimed in claim 1 or 3, wherein the projections are formed in the flow path extending in a site away from the heat source being in contact with the upper plate.

6. The cooling device as claimed in claim 1 or 2, wherein the lower plate comprises a plurality of ridges formed in parallel to one another to form the flow path, and the ridges are joined to the upper plate.

7. The cooling device as claimed in claim 1 or 3, wherein the projections are formed integrally with any one of the upper plate and the lower plate.
